# EUROPEAN PATENT APPLICATION

(11) **EP 2 871 644 A1**
(43) Date of publication of application: **13.05.2015**
(21) Application number: 13812839.2
(22) Date of filing: 28.02.2013
(51) Int. Cl.: H01B 13/00, B22F 3/22, B22F 7/04, H05K 3/12, B22F 9/00

(54) **METHOD FOR FORMING CONDUCTIVE FILM AND SINTERING PROMOTER**

(30) Priority: 03.07.2012 JP 2012149011
(71) Applicant: Ishihara Chemical Co., Ltd., Kobe-shi Hyogo 652-0806 (JP)
(72) Inventor: KAWATO, Yuichi, Kobe-shi, Hyogo 652-0806 (JP); MAEDA, Yusuke, Kobe-shi, Hyogo 625-0806 (JP); KUDO, Tomio, Kobe-shi, Hyogo 652-0806 (JP)
(74) Representative: Hoefer & Partner
(86) International application number: PCT/JP2013/055416
(87) International publication number: WO 2014/006933

(57) **Abstract**

In a conductive film forming method using photo sintering, a conductive film having low electric resistance is easily formed.

The conductive film forming method is a method in which a conductive film 5 is formed using photo sintering. This method includes the steps of forming a layer 22 made of a sintering promoter 2 on a substrate, forming a liquid film 3 made of a copper particulate dispersion on the layer 22 of the sintering promoter 2, drying the liquid film 3 to form a copper particulate layer 4, and subjecting the copper particulate layer 4 to photo sintering. The sintering promoter 2 is a compound which removes copper oxide from metallic copper. Thereby, the sintering promoter 2 removes a surface oxide film of copper particulates 31 in photo sintering.

## Description

### TECHNICAL FIELD

The present invention relates to a conductive film forming method using photo sintering, and a sintering promoter which allows photo sintering to proceed in the conductive film forming method.

### BACKGROUND ART

There has hitherto existed a printed board in which a circuit composed of a copper foil is formed on a substrate by photolithography. Photolithography requires the step of etching a copper foil and high costs are required for a treatment of waste fluid generated by etching and the like.

There has been known, as the technology requiring no etching, a method in which a conductive film is formed on a substrate using a copper particulate dispersion (copper ink) containing copper particulates (copper nanoparticles) dispersed in a dispersion vehicle (see, for example, Patent Document 1). According to this method, a liquid film of a copper particulate dispersion is formed on a substrate, and the liquid film is dried to form a copper particulate layer. The copper particulate layer undergoes photo sintering by light irradiation, and thus a conductive film having low electric resistance is formed. However, in the above-mentioned method, photo sintering may not sufficiently proceed even if energy of light irradiated in photo sintering is large, and thus failing to form a conductive film having low electric resistance.

### PRIOR ART DOCUMENT

Patent Document 1: U.S. Patent Application Serial No. 2008/0286488

### SUMMARY OF THE INVENTION

### PROBLEMS TO BE SOLVED BY THE INVENTION

The present invention is made so as to solve the above-mentioned problems and an object thereof is to easily form a conductive film having low electric resistance in a conductive film forming method using photo sintering.

### MEANS FOR SOLVING THE PROBLEMS

A conductive film forming method of the present invention is a method in which a conductive film is formed using photo sintering, and is characterized by including the steps of: forming a layer made of a sintering promoter on a substrate, forming a liquid film made of a copper particulate dispersion on the layer of the sintering promoter, drying the liquid film to form a copper particulate layer, and subjecting the copper particulate layer to photo sintering, the sintering promoter being a compound which removes copper oxide from metallic copper.

In this conductive film forming method, the sintering promoter is preferably selected from the group consisting of amides, imides, ketones, urethanes, thioethers, carboxylic acids and phosphoric acids.

In this conductive film forming method, the sintering promoter is preferably selected from polyvinylpyrrolidone, a polyamideimide resin, a polyurethane resin, a polyphenylene sulfide resin and hydroxyethylidenediphosphonic acid. In this conductive film forming method, the sintering promoter may be selected from the group consisting of alcohols, saccharides, aldehydes, hydrazines, quinones, phenols and amines.

In this conductive film forming method, the sintering promoter may be selected from the group consisting of polyvinyl alcohol, hydroquinone and a silane coupling agent.

A sintering promoter of the present invention is used in the above conductive film forming method.

### ADVANTAGES OF THE INVENTION

According to the present invention, since a sintering promoter removes a surface oxide film of copper particulates in photo sintering, copper particulates, from which the surface oxide film has been removed, are sintered and a copper particulate layer undergoes bulking, and thus a conductive film having low electric resistance is easily formed.

### BRIEF DESCRIPTION OF THE DRAWINGS

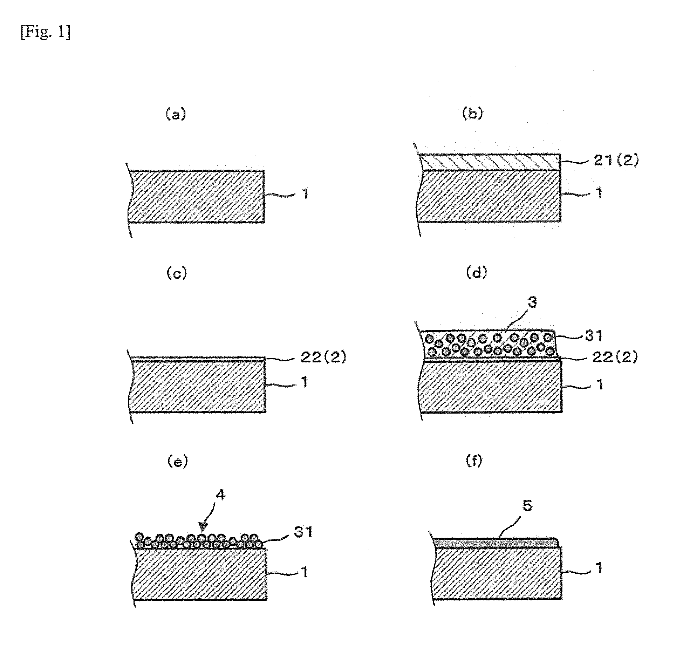

[Fig. 1] Figs. 1(a) to 1(f) are cross-sectional schematic views showing formation of a conductive film by a conductive film forming method according to an embodiment of the present invention in chronological order.

### BEST MODE FOR CARRYING OUT THE INVENTION

A conductive film forming method according to an embodiment of the present invention will be described with reference to Figs. 1(a) to 1(f). As shown in Figs. 1(a) and 1(b), a solution 21 containing a sintering promoter 2 is applied on a substrate 1. As shown in Fig. 1(c), a solvent of the solution 21 is dried to form a layer 22 made of the sintering promoter 2.

The substrate 1 is obtained by forming a base material into a plate shape. Examples of the base material include, but are not limited to, glass, a resin, ceramics, a silicon wafer and the like.

The sintering promoter 2 is a compound which removes copper oxide from metallic copper. The sintering promoter 2 may be, for example, amides, imides, ketones, urethanes, thioethers, carboxylic acids or phosphoric acids, and examples thereof include, but are not limited to, polyvinylpyrrolidone among amides, a polyamideimide resin among imides, a polyurethane resin among urethanes, a polyphenylene sulfide resin among thioethers, and hydroxyethylidenediphosphonic acid among phosphoric acids. It is considered that such sintering promoter 2 removes copper oxide from metallic copper by etching.

The sintering promoter 2 may be alcohols, saccharides, aldehydes, hydrazines, quinones, phenols or amines, and examples thereof include, but are not limited to, polyvinyl alcohol among alcohols, hydroquinone among quinones, a silane coupling agent among amines and the like. Such sintering promoter 2 removes copper oxide from metallic copper by reducing the copper oxide.

These sintering promoters 2 may be used alone, or two or more kinds of sintering promoters may be appropriately mixed and used.

As shown in Fig. 1(d), a liquid film 3 made of a copper particulate dispersion is formed on a layer 22 of the sintering promoter 2. The copper particulate dispersion is a liquid containing copper particulates 31 dispersed therein, and includes copper particulates 31, a dispersion vehicle and a dispersant. Copper particulates 31 are, for example, copper nanoparticles having a median particle diameter of 1 nm or more and less than 100 nm. The dispersion vehicle is a liquid vehicle containing copper particulates 31. The dispersant enables copper particulates 31 to disperse in the dispersion vehicle. Copper particulates 31 are coated with a thin surface oxide film since a particle surface is oxidized by oxygen in air.

A liquid film 3 is formed, for example, by a printing method. In a printing method, a copper particulate dispersion is used as a printing ink, and a predetermined pattern is printed on a layer 22 of a sintering promoter 2 and the liquid film 3 with the pattern is formed. Since the copper particulate dispersion is used as an ink, it is also called a copper ink. The sintering promoter 2 is eluted in the liquid film 3 by being in contact with the liquid film 3.

Next, the liquid film 3 is dried. As shown in Fig. 1 (e), the copper particulates 31 and the sintering promoter 2 remain on the substrate 1 by drying the liquid film 3 to form a copper particulate layer 4 composed of copper particulates 31 on the substrate 1. A surface of the copper particulates 31 in the copper particulate layer 4 is in contact with the sintering promoter 2. In Fig. 1 (e), illustration of the sintering promoter 2 is omitted.

Next, a copper particulate layer 4 is irradiated with light and the copper particulate layer 4 is subjected to photo sintering. Photo sintering is performed at room temperature under atmospheric air. A light source used in photo sintering is, for example, a xenon lamp. A laser device may be used as the light source. In photo sintering, a surface oxide film of copper particulates 31 is removed, and also copper particulates 31 is sintered and the copper particulate layer 4 undergoes bulking. As shown in Fig. 1 (f), the copper particulate layer 4 undergoes bulking to form a conductive film 5.

It has hitherto been considered that the surface oxide film of copper particulates 31 is reduced to copper by a photoreduction reaction due to energy of light in photo sintering and then removed.

However, according to the test performed by the inventors of the present invention, the copper particulate layer 4 may undergo insufficient bulking even if energy of light irradiated in photo sintering is large, depending on the copper particulate dispersion. Since too large energy of light irradiated on the copper particulate layer 4 may cause damage of the copper particulate layer 4, there is a limitation on magnitude of energy of light irradiated in photo sintering. The inventors of the present invention considered that there may be some cases where the surface oxide film of copper particulates 31 is not sufficiently removed only by energy of light, and thus photo sintering does not proceed sufficiently, leading to insufficient bulking of the copper particulate layer 4. The inventors of the present invention have found by the test that photo sintering is allowed to proceed by use of a compound which removes copper oxide from metallic copper. In a conductive film forming method of the present embodiment, a sintering promoter 2 is a compound which removes copper oxide from metallic copper, and removes a surface oxide film of copper particulates 31. Light irradiation to the copper particulate layer 4 promotes chemical reaction in which the sintering promoter 2 enables copper oxide to be removed from copper particulates 31. Copper particulates 31, from which the surface oxide film has been removed, are sintered by energy of light, and thus copper particulate layer 4 undergoes bulking to form a conductive film 5 having conductivity.

As mentioned above, according to a conductive film forming method of the present embodiment, since the sintering promoter 2 enables a surface oxide film of copper particulates 31 to be removed in photo sintering, copper particulates 31, from which the surface oxide film has been removed, are sintered and the copper particulate layer 4 undergoes bulking, and thus a conductive film 5 having low electric resistance is easily formed.

In case the sintering promoter 2 enables etching of copper oxide, the surface oxide film of copper particulates 31 is removed by etching.

In case the sintering promoter 2 enables reduction of copper oxide, the surface oxide film of copper particulates 31 is removed by reduction.

In Examples, using a conductive film forming method of the present invention, a conductive film 5 was formed and electric resistance of the thus formed conductive film 5 was measured.

### [Example 1]

A non-alkali glass was used as a substrate 1. Using amides such as polyvinylpyrrolidone (having a molecular weight of 630,000) as a sintering promoter 2 and using water as a solvent, a solution containing a sintering promoter 2 was prepared. The concentration of the sintering promoter 2 was adjusted to 10%. This solution was applied on a substrate 1 in a predetermined thickness by a spin coating method. In order to dry a solvent in the solution, the substrate 1 coated with the solution was dried under atmospheric air at 100°C to 250°C for 30 minutes to form a layer 22 of a sintering promoter. A copper particulate dispersion (manufactured by ISHIHARA CHEMICAL CO., LTD. under the trade name of "CJ-0104") was applied on the layer 22 of the sintering promoter in a predetermined thickness by a spin coating method. The substrate 1 coated with the copper particulate dispersion was dried under atmospheric air at 100°C for 30 minutes, and then subjected to photo sintering using a flash irradiation device with a xenon lamp to produce a sample substrate. Light irradiation in this photo sintering was carried out at magnitude of energy within a range from 0.5 J/cm² to 30 J/cm² for 0.1 ms to 10 ms. The copper particulate layer 4 exhibited a black color before photo sintering. After photo sintering by single light irradiation, the surface changed color to a copper color. The copper color is the color of bulk copper, and it was found from the change in color due to photo sintering that the copper particulate layer 4 underwent bulking to form a conductive film 5. There was no need of performing light irradiation for more than once. Sheet resistance of the conductive film 5 on the test substrate showed a low value of 200 mΩ/□.

### [Example 2]

Using a polyamideimide resin among amideimides as the sintering promoter 2 and using propylene carbonate as the solvent, a solution containing the sintering promoter 2 was prepared. The concentration of the sintering promoter 2 was adjusted to 10%. In the same manner as in Example 1, except for that mentioned above, a test substrate was produced. The copper particulate layer 4 exhibited a black color before photo sintering. After photo sintering by single light irradiation, the surface changed color to a copper color. Sheet resistance of the conductive film 5 on the test substrate showed a low value of 280 mΩ/□.

### [Example 3]

Using a silane coupling agent (3-aminopropyltriethoxysilane) among amines as the sintering promoter 2 and using water as the solvent, a solution containing the sintering promoter 2 was prepared. The concentration of the sintering promoter 2 was adjusted to 1%. In the same manner as in Example 2, except for that mentioned above, a test substrate was produced. The copper particulate layer 4 exhibited a black color before photo sintering. After photo sintering by single light irradiation, the surface changed color to a copper color. Sheet resistance of the conductive film 5 on the test substrate showed 200 mΩ/□.

### [Example 4]

### Using another silane coupling agent

(N-2-(aminoethyl)-3-aminopropyltriethoxysilane) as the sintering promoter 2 and using water as the solvent, a solution containing the sintering promoter 2 was prepared. The concentration of the sintering promoter 2 was adjusted to 1%. In the same manner as in Example 3, except for that mentioned above, a test substrate was produced. The copper particulate layer 4 exhibited a black color before photo sintering. After photo sintering by single light irradiation, the surface changed color to a copper color. Sheet resistance of the conductive film 5 on the test substrate showed 200 mΩ/□.

### [Example 5]

Using polyvinyl alcohol (having a molecular weight of 2,000) among alcohols as the sintering promoter 2 and using water as the solvent, a solution containing the sintering promoter 2 was prepared. The concentration of the sintering promoter 2 was adjusted to 10%. In the same manner as in Example 4, except for that mentioned above, a test substrate was produced. The copper particulate layer 4 exhibited a black color before photo sintering. After photo sintering by single light irradiation, the surface changed color to a copper color. Sheet resistance of the conductive film 5 on the test substrate showed 300 mΩ/□.

### [Example 6]

Using a polyurethane resin among urethanes as the sintering promoter 2 and using propylene carbonate as the solvent, a solution containing the sintering promoter 2 was prepared. The concentration of the sintering promoter 2 was adjusted to 35%. In the same manner as in Example 5, except for that mentioned above, a test substrate was produced. The copper particulate layer 4 exhibited a black color before photo sintering. After photo sintering by single light irradiation, the surface changed color to a copper color. Sheet resistance of the conductive film 5 on the test substrate showed 250 mΩ/□.

### [Example 7]

Using a polyphenylene sulfide resin among thioethers as the sintering promoter 2 and using 2-propanol as the solvent, a solution containing the sintering promoter 2 (dispersion) was prepared. The concentration of the sintering promoter 2 was adjusted to 1%. In the same manner as in Example 6, except for that mentioned above, a test substrate was produced. The copper particulate layer 4 exhibited a black color before photo sintering. After photo sintering by single light irradiation, the surface changed color to a copper color. Sheet resistance of the conductive film 5 on the test substrate showed 170 mΩ/□.

### [Example 8]

Using hydroxyethylidenediphosphonic acid among phosphoric acids as the sintering promoter 2 and using water as the solvent, a solution containing the sintering promoter 2 was prepared. The concentration of the sintering promoter 2 was adjusted to 49%. In the same manner as in Example 7, except for that mentioned above, a test substrate was produced. The copper particulate layer 4 exhibited a black color before photo sintering. After photo sintering by single light irradiation, the surface changed color to a copper color. Sheet resistance of the conductive film 5 on the test substrate showed 150 mΩ/□.

### [Example 9]

Using hydroquinone among quinones as the sintering promoter 2 and using propylene carbonate as the solvent, a solution containing the sintering promoter 2 was prepared. The concentration of the sintering promoter 2 was adjusted to 10%. In the same manner as in Example 8, except for that mentioned above, a test substrate was produced. The copper particulate layer 4 exhibited a black color before photo sintering. After photo sintering by single light irradiation, the surface changed color to a copper color. Sheet resistance of the conductive film 5 on the test substrate showed 300 mΩ/□.

As mentioned above, use of the sintering promoter 2 enabled the formation of a conductive film 5 having low electric resistance.

The present invention is not limited to configurations of the above-mentioned embodiments, and various modifications can be made without departing from the spirit or scope of the present invention. For example, the surface shape of the substrate 1 is not limited to a plane and may be a curved surface or a combination of a plurality of planes.

### EXPLANATION OF SYMBOLS

- 1 :: Substrate
- 2 :: Sintering promoter
- 3 :: Liquid film
- 31 :: Copper particulates
- 4 :: Copper particulate layer
- 5 :: Conductive film

## Claims

1. A conductive film forming method in which a conductive film is formed using photo sintering, which comprises the steps of:
forming a layer made of a sintering promoter on a substrate,
forming a liquid film made of a copper particulate dispersion on the layer of the sintering promoter,
drying the liquid film to form a copper particulate layer, and
subjecting the copper particulate layer to photo sintering, wherein
the sintering promoter is a compound which removes copper oxide from metallic copper.

2. The conductive film forming method according to claim 1, wherein the sintering promoter is selected from the group consisting of amides, imides, ketones, urethanes, thioethers, carboxylic acids and phosphoric acids.

3. The conductive film forming method according to claim 2, wherein the sintering promoter is selected from the group consisting of polyvinylpyrrolidone, a polyamideimide resin, a polyurethane resin, a polyphenylene sulfide resin and hydroxyethylidenediphosphonic acid.

4. The conductive film forming method according to claim 1, wherein the sintering promoter is selected from the group consisting of alcohols, saccharides, aldehydes, hydrazines, quinones, phenols and amines.

5. The conductive film forming method according to claim 4, wherein the sintering promoter is selected from the group consisting of polyvinyl alcohol, hydroquinone and a silane coupling agent.

6. A sintering promoter which is used in the conductive film forming method according to any one of claims 1 to 5.
